# EUROPEAN PATENT APPLICATION

(11) **EP 3 893 316 A1**
(43) Date of publication of application: **13.10.2021**
(21) Application number: 20168693.8
(22) Date of filing: 08.04.2020
(51) Int. Cl.: H01M 10/42, H01M 10/48, B60L 58/12, B60L 58/16, B60L 58/18, B60L 58/24, G01R 31/36, G01R 31/367, G01R 31/374, G01R 31/387, H01M 4/131, H01M 4/485, H01M 10/052

(54) **BATTERY STATE ESTIMATION WITH POWER CONVERTER**

(71) Applicant: ABB Schweiz AG, 5400 Baden (CH)
(72) Inventor: Wicki, Stefan, 5702 Niederlenz (CH); Andersson, Caroline, 8032 Zurich (CH); Baur, Matthias, 5034 Suhr (CH); CuervoReyes, Eduardo, 8050 Zürich (CH)
(74) Representative: Qip Patentanwälte Dr. Kuehn & Partner mbB

(57) **Abstract**

A battery device (22) is connected with an electrical converter (18) for supplying and/or driving a high power system (10). A method for estimating a state (54) of a battery device (22) comprises: controlling the electrical converter (18) to generate an excitation signal (56) for the battery device (22), wherein the excitation signal (56) is generated for a plurality of frequencies; measuring a current (58) through the battery device (22) and a voltage (60) across the battery device (22) for the plurality of frequencies; determining impedance values (64) of the battery device (22) for the plurality of frequencies from the current (58) and the voltage (60) measured at the plurality of frequencies; estimating the state (54) of the battery device (22) from the impedance values (64).

## Description

### FIELD OF THE INVENTION

The invention relates to a method, a computer program, a computer-readable medium and a controller for estimating a state of a battery device. Additionally, the invention relates to a power supply for a high-power system.

### BACKGROUND OF THE INVENTION

The state of health of a battery, either for an assembled battery device or on battery cell level, are very important parameters in a battery storage system. However, it is one of the most difficult parameters to assess in a correct way, especially as the battery cells degrade over time. Most battery manufacturers perform a complete discharge and charge cycle to identify the capacity and therefore the state of health of a battery.

### DESCRIPTION OF THE INVENTION

It is an objective of the invention to provide an accurate and economic way for determining a state of a battery for high-power applications.

This objective is achieved by the subject-matter of the independent claims. Further exemplary embodiments are evident from the dependent claims and the following description.

An aspect of the invention relates to a method for estimating a state of a battery device. A battery device may be a device comprising one or more electrochemical battery cells. The battery cells may be connected in parallel and/or in series. The battery furthermore may comprise and/or may be interconnected with a controller, which is adapted for performing the method.

According to an embodiment of the invention, the battery device is connected with an electrical converter for supplying and/or driving a high power system. The electrical converter may be a high power device, i.e. may be adapted for processing a current of more than 100 A and/or a voltage of more than 400 V. The high power system also may be adapted for being operated with a current of more than 100 A and/or a voltage of more than 400 V. For example, the high power system may comprise a generator and/or an electrical motor. The high power system may be the drive system of an electrical vehicle, such as a traction vehicle. In this case, the electrical converter may drive the drive system.

It may be that in a normal operation mode, the electrical converter is controlled to supply power from the battery device to the high power system and/or that the electrical converter is controlled to charge the battery device with power from the high power system. This control may be performed by a controller of the electrical converter.

According to an embodiment of the invention, the method for estimating a state of a battery device comprises: controlling the electrical converter to generate an excitation signal for the battery device, wherein the excitation signal is generated for a plurality of frequencies. During a testing operation mode, the electrical converter generates an excitation signal for the battery device. The excitation signal may be an AC signal and/or may be a current and/or voltage applied to the battery device. For example, the excitation signal may be a sinusoidal signal and/or a pulsed signal. It may be that, when the excitation signal is generated, the battery is charged and/or discharged.

The excitation signal is generated for a plurality of frequencies. This may mean that a frequency of the excitation signal is changed over time. The excitation signal may be generated for a discrete set of frequencies and/or for a frequency range.

According to an embodiment of the invention, the method further comprises: measuring a current through the battery device and a voltage across the battery device for the plurality of frequencies. A current may be measured in a supply line for the battery device. It also may be that a current is measured in a supply line for battery cells of the battery device. Analogously, a voltage may be measured between inputs of the battery device. It also may be that a voltage is measured between inputs of each battery cell of the battery device. For the current and the voltage, a magnitude and/or a frequency may be determined.

For each frequency or at least some of the frequencies, at which the excitation signal is generated, such current measurements and voltage measurements may be performed.

According to an embodiment of the invention, the method further comprises: determining impedance values of the battery device for the plurality of frequencies from the current and the voltage measured at the plurality of frequencies and estimating the state of the battery device from the impedance values.

For each frequency or at least some of the frequencies, at which the excitation signal is generated, an impedance value may be determined. An impedance value may be a complex value having a real part and an imaginary part. In such a way, an impedance curve and/or at least a set of impedances for a range and/or a set of frequencies is generated. From these impedances, a state of the battery device may be estimated.

In particular, the battery device may be modelled with an equivalent circuit and parameters from this equivalent circuit may be estimated from the impedances. From these parameters, the state of the battery device, such as a state of health, a state of charge and/or other states, such as a temperature may be determined. In general, a state may be a number, which indicates a physical state of the battery device.

With the method, the state of a battery device may be estimated with the aid of the connected electrical converter, which is also used for charging and/or discharging the battery device. Several parameters of the battery device may be extracted, such as state of health of a battery, state of charge of a battery or any other interesting parameter.

No additional measurement equipment is needed for the state estimation. Furthermore, for high power applications, a standard impedance spectrometer may not provide the power to excite all battery cells of the overall battery storage system. With the converter as excitation source this may become possible.

In such a way, a better safety of the battery device may be achieved due to better knowledge of the state of health of the battery device. Also, the use of several indicators and/or parameters, which can be extracted from the impedances and/or the impedance curve, allows to deconvolute effect of state of health, state of charge and/or and internal temperature. A single measurement of capacity may not be enough. DC resistance measurements may be prohibited due to the long time required and continuous change in state of the battery.

According to an embodiment of the invention, the excitation signal is generated in a frequency range, in which the battery device behaves like a Warburg impedance. The equivalence circuit of the battery device may comprise a Warburg impedance. A Warburg impedance may have a slope of 45° in a Nyquist diagram, in which the impedances are depicted. The crossing of a line having a slope like a Warburg impedance and an axis of the Nyquist diagram may be a parameter, from which the state of the battery device may be determined.

According to an embodiment of the invention, the battery device is connected via an electrical filter with the electrical converter. In many applications, the battery device and the electrical converter may be connected via a filter for smoothing higher order harmonics generated by the electrical converter. Such an electrical filter may comprise inductors and optionally capacitors. The electrical filter may filter out frequencies above a filter frequency of 200 Hz, in particular above 120 Hz, and thus an excitation signal with frequencies higher than the filter frequency may not be used for determining the state of the battery device.

However, when parameters are derived from the impedances, which may be determined for frequencies below the filter frequency, then the state of the battery device may de estimated even when an electrical filter is present. No additional equipment may be needed for estimating the state of the battery device.

According to an embodiment of the invention, the plurality of frequencies are in a frequency range with an upper limit of 200 Hz or with an upper limit of 120 Hz. Such a frequency range may be accessible for usual electrical filters. The frequency range may have a lower limit higher than 0 Hz, such as 1 Hz or 10 Hz.

According to an embodiment of the invention, the converter is controlled to scan a frequency range with the excitation signal. For example, the excitation signal may be generated with a frequency at a lower limit, such as 1 Hz. The frequency then may be continuously increased to an upper limit, for example such as described above.

According to an embodiment of the invention, the state is one of temperature, state of charge and state of health of the battery device. From the impedance values and/or the impedance curve, several different type of states may be estimated, in particular, when other parameters from the battery device, such as an external temperature, are known and/or measured.

According to an embodiment of the invention, an external battery device temperature is measured with a temperature sensor. For example, such a temperature may be determined from a temperature of a heat transfer fluid for cooling and/or heating the batteries. The state of the battery device then may be an internal temperature of the battery device, which is estimated from the external battery device temperature and the impedance values. This estimation may be performed, when a constant state of charge is known for the battery device. The estimation may be based on a Warburg impedance determined from the impedance values.

According to an embodiment of the invention, a battery device temperature is measured with a temperature sensor. This again may be the external battery device temperature. However, it also may be that each battery cell of the battery device has a temperature sensor for directly measuring the battery device temperature. The state of the battery device may be a state of health of the battery device, which is estimated from the battery device temperature and the impedance values. The estimation may be based on a Warburg impedance determined from the impedance values.

According to an embodiment of the invention, the battery device is at least a part of a battery storage system. The battery storage system together with the electrical converter and optionally the electrical filter may form a power supply. The battery storage system may be connected to the electrical converter and/or the excitation signal may be supplied to the battery storage system.

The battery storage system may comprise a plurality of battery cells, which are connected in parallel and/or in series. For example, the battery device may be a group of battery cells connected in parallel and/or in series. The battery device may be a battery cell, comprises at least two battery cells or is the battery storage system. A state for the battery device may be estimated for each battery cell, for specific groups of battery cells and/or for the complete battery storage system.

According to an embodiment of the invention, the battery device comprises a Lithium-Titanite battery cell. Such battery cells may be modelled with an equivalent circuit having a series connected Warburg impedance for lower frequencies, such as lower than 200 Hz.

According to an embodiment of the invention, the high power system is a vehicle, for example a traction vehicle. A traction vehicle may be a train or tram. The vehicle also may be a bus. The method may be performed for a battery device of the vehicle, which is used to buffer electrical energy. For a traction vehicle, in one operation mode, the electrical energy may be supplied via a catenary line.

A further aspect of the invention relates to a computer program for estimating a state of a battery device, which, when being executed on a processor, is adapted for performing the method as described herein. The method may be performed by a controller of the electrical converter and/or of the battery device.

A further aspect of the invention relates to a computer-readable medium on which such a computer program is stored. The computer-readable medium may be a memory of the controller mentioned above. In general, a computer-readable medium may be a floppy disk, a hard disk, an USB (Universal Serial Bus) storage device, a RAM (Random Access Memory), a ROM (Read Only Memory), an EPROM (Erasable Programmable Read Only Memory) or a FLASH memory. A computer-readable medium may also be a data communication network, e.g. the Internet, which allows downloading a program code. In general, the computer-readable medium may be a non-transitory or transitory medium.

A further aspect of the invention relates to a controller for estimating a state of a battery device, which controller is adapted for performing the method as described herein. As already mentioned, the controller may be a controller of the electrical converter and/or of the battery device. The controller also may perform other tasks, such as the charging and/or discharging of the battery device, monitoring tasks of the battery device, etc.

A further aspect of the invention relates to a power supply for a high-power system. The power supply may comprise a battery storage system comprising a plurality of battery cells, a battery device composed of at least some of the battery cells, a converter connected to the battery storage system and adapted for supplying and/or driving the high-power system and a controller for estimating a state of a battery device, which is composed of one, some or all of the battery cells. The method may be performed for each battery cell individually, for groups of battery cells and/or for the complete battery storage system.

The power supply may be a power supply for an electrical vehicle and the high-power system may be the drive system of an electrical vehicle. In particular, the electrical vehicle may be a vehicle, such as a train, tram or bus. However, the high-power system also may be a power quality improvement device, which may be connected to an electrical grid.

With the method and the power supply, cost may be reduced caused by an early exchange of battery cells due to delayed ageing, since state of health monitoring of individual cells may be performed. Data acquisition for state estimation may be integrated in the power supply for future use, for example for product development. A deeper understanding of the stress-performance-degradation relationships in a battery based high power supply may be achieved.

In general, it has to be understood that features of the method, the computer program, the computer-readable medium and the controller as described in the above and in the following may be features of the power supply as described in the above and in the following and vice versa.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a high power system according to an embodiment of the invention.
Fig. 2 shows a schematic circuit diagram of a power supply system according to an embodiment of the invention.
Fig. 3 shows a flow diagram for a method for estimating a state of a battery device according to an embodiment of the invention.
Fig. 4 shows a diagram illustrating an impedance curve and an equivalent circuit used in an embodiment of the invention.
Fig. 5 shows a diagram illustrating impedance curves used in an embodiment of the invention.
Fig. 6 shows a diagram illustrating further impedance curves used in an embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

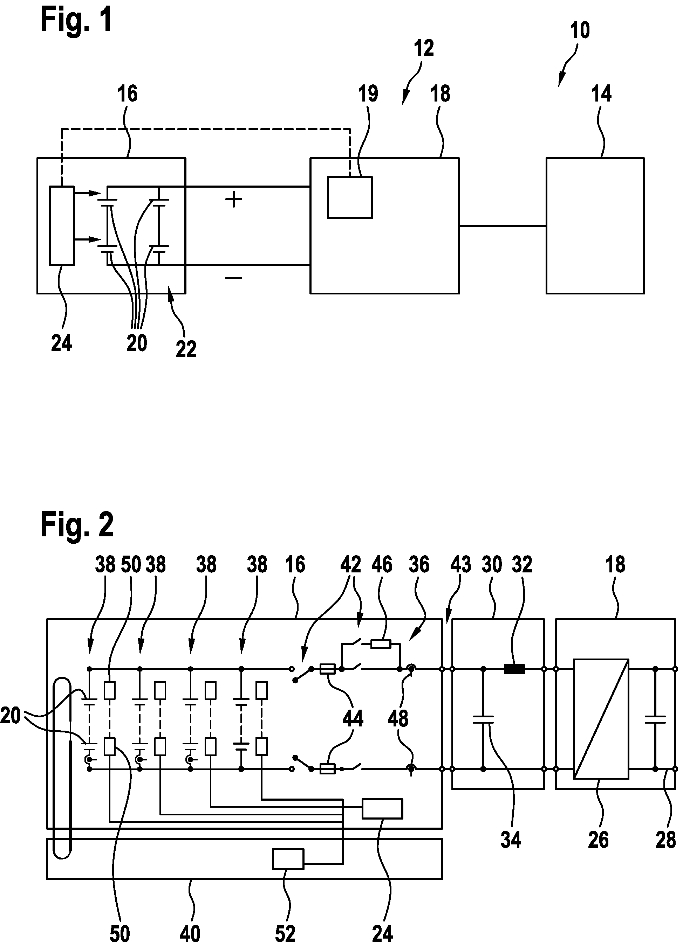

Fig. 1 shows a high power system 10, which comprises a battery power supply 12 and a high power device 14. The high power system 10 may be a traction vehicle, such as a train or tram, and the high power device 14 may comprise or may be connected to an electrical motor.

The power supply 12 comprises a battery storage system 16 and an electrical converter 18. The electrical converter 18 may convert a current from the battery storage system 16 into a current to be supplied to the high power device 14 and/or may convert a current from the high power device 14 into a current to be supplied to the battery storage system 16, i.e. for charging the battery storage system 16. The electrical converter 18 may comprise a controller 19, which is adapted for performing these tasks.

The battery storage system 16 comprises a plurality of battery cells 20, which may be connected in parallel and/or in series. One, all or some of the battery cells 20 may form a battery device 22 for which a state is estimated, as described above and below. The battery cells 20 may be Lithium-Titanite battery cells.

The battery storage system 16 comprises a controller 24, which may perform the estimation. The controller 24, which also may perform other tasks, may be connected with the controller 19 of the electrical converter and may command the controller 19 to generate an excitation signal for the battery storage system 16. The controller 24 may be adapted for measuring voltages and currents in the battery storage system 16, which may be used for estimating the state of the battery device 22.

Fig. 2 shows a circuit diagram of a power supply 12. The electrical converter may comprise a DC-to-DC converter 26, such as a chopper, and a DC link 28. The DC-to-DC converter 26 may be adapted for generating a pulsed and/or AC signal applied to the battery storage system 16.

It may be that an electrical filter 30 is interconnected between the electrical converter 18 and the battery storage system 16. The electrical filter 30 may comprise an inductor 32 and/or a capacitor 34.

The battery storage system 16 comprises a protection and connection circuit 36, a plurality of battery modules 38 and a battery thermal management unit 40.

The protection and connection circuit 36, which is situated at the input 43 of the battery storage system 16, comprises switches 42, fuses 44 and further electric elements 46, which are used for interconnecting the battery modules 38 with the input 43 and for protecting the battery modules 38 from overcurrents. A current into the battery storage system 16 can be measured with current sensors 48 interconnected into the input 43.

The battery modules 38 may be connected in parallel. Each of the battery modules 38 may comprise a plurality of series-connected battery cells 20. The battery cells 20 may be Lithium-Titanite battery cells. For example, the battery device 22 may be one of these battery cells 20 or a battery module 38. Each battery cell 20 comprises a battery cell monitoring unit 50, which may be adapted for measuring a voltage across the battery cell 20 and/or for measuring a temperature of the battery cell 20.

The battery cell monitoring units 50 are connected with the controller 24 and may send the measured voltages and/or temperatures to the controller 24.

The battery thermal management unit 40 is adapted for cooling and/or heating the battery modules 38, for example via liquid heat transfer. A battery thermal management unit controller 52 may measure a heat transfer fluid temperature, which may be sent to the controller 24. The heat transfer fluid temperature may be indicative of an average temperature of the battery cells 20.

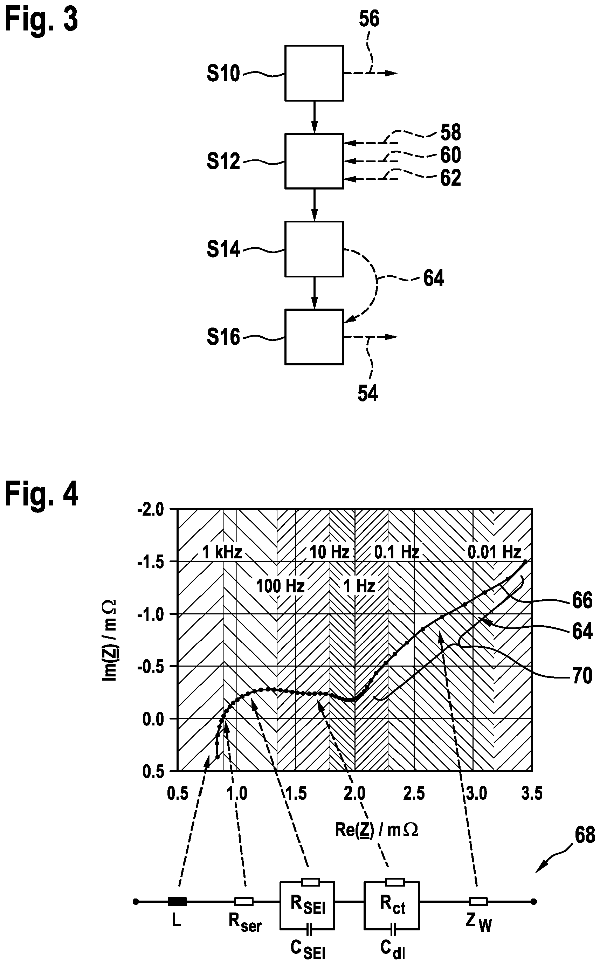

Fig. 3 shows a flow diagram for a method for estimating a state 54 of a battery device 22. The method may be performed by the controllers 19, 24.

In step S10, the electrical converter 18 is controlled to generate an excitation signal 56 for the battery device 22. For example, the controller 24 may command the controller 19 to generate the excitation signal 56. The excitation signal 56 is generated for a plurality of frequencies, for example via scanning a frequency range.

The electrical converter 18, which is used in a normal operation mode for charging and/or discharging the battery storage system 16, is used as excitation source to stimulate the battery device 22 with the excitation signal 56. The excitation signal 56 may have different waveforms, for example a sinus waveform, where the frequency will be changed, a pulsed signal, or also other applicable waveforms. The excitation signal 56 may be generated by control of the controller 19 of the electrical converter.

As will be described below, it may be beneficial, in particular, when an electrical filter 30 is present, that the excitation signal 56 is generated in a frequency range, in which the battery device 22 behaves like a Warburg impedance. For electrical filters 30 as used in many applications, the frequency range may have an upper limit of about 200 Hz and lower, such as 120 Hz.

In step S12, a current 58 through the battery device 22 and a voltage 60 across the battery device 22 is measured for the plurality of frequencies. The excitation signal 56 and the reaction of the battery device 22 to this excitation signal 56 may be measured with sensors which may be located in the electrical converter 18 and/or the battery storage system 16. These sensors may be connected to the controller 19 of the electrical converter 18 and/or to the controller 24 of the battery storage system 16.

For example, the current 58 may be measured by the sensors 48. The voltage 60 may be measured by the cell monitoring units 50 for each battery cell 20. It has to be noted that a state 54 of each battery cell 20 may be determined with the method.

It also may be that a battery device temperature 62 is measured for the battery device 22. Such a temperature may be measured with a temperature sensor of the battery thermal management unit 40, which then may indicate an average temperature of all battery cells 20. It also may be that such a temperature is measured with a temperature sensor of the cell monitoring units 50.

In step S14, impedance values 64 of the battery device 22 are determined for the plurality of frequencies from the current 58 and the voltage 60 measured at the plurality of frequencies.

Fig. 4 shows a Nyquist plot with impedance values 64 that have been determined from current and voltage measurements at different frequencies of a Lithium-Titanite battery cell 20. The Nyquist plot shows the real part of the impedance Z to the right and the imaginary part of the impedance Z on the vertical axis.

The impedance values 64 have been connected to an impedance curve 66. The frequencies have been scanned from a frequency value of nearly 0 Hz to a value of more than 1 kHz. The vertical lines in the diagram show, which parts of the impedance curve 66 are associated with which frequency ranges.

Below the Nyquist plot, an equivalent circuit 68 for the associated battery cell 20 is shown. The equivalence circuit 68 is a second order Randles circuit, which comprises a battery inductance L, a battery resistance R, two resistive-capacitive elements and a Warburg impedance Z_{W} connected in series. The first resistive-capacitive element comprises a resistance R_{SEI} and a capacitance C_{SEI} for the solid electrolyte interface. The second resistive-capacitive element comprises a charge transfer resistance R_{ct} and a double layer capacitance C_{dl}. It has to be noted that other types of electrolytic cells may be better modelled with different equivalent circuits. However, all types of electrolytic cells have a Warburg impedance comparable to the one of the present equivalent circuit 68.

Arrows in the diagram indicate, which parts of the impedance curve 66 are related to which part of the equivalent circuit 68. In particular, it can be seen that the parts associated with frequencies below about 200 Hz are mainly related to the Warburg impedance Z_{W}.

Thus, when the frequencies scanned by the estimation method are located in a frequency range 70 below such a limiting frequency, the Warburg impedance Z_{W} and its parameters can be determined from the determined impedances 64. Such parameters may include a crossing of the horizontal axis and a line fitted to the linear part of the impedance curve 66 in the range 70. As will be shown below, from such parameters, states of a battery device 22, which may be or may be composed of such battery cells 20 may be estimated.

In step S16, the state of the battery device 22 is estimated from the impedance values 62, which may have been determined in the frequency range 70. For example, such a state 54 may be a temperature, state of charge and/or state of health of the battery device 22.

In general, states and parameters of the battery device 22 may be determined from the impedance values 64. For example, as shown in Fig. 4, parameters of an equivalent circuit 68 can be determined from the impedance values 64. From these parameters, which themselves may be seen as states, the desired state 54 may be determined.

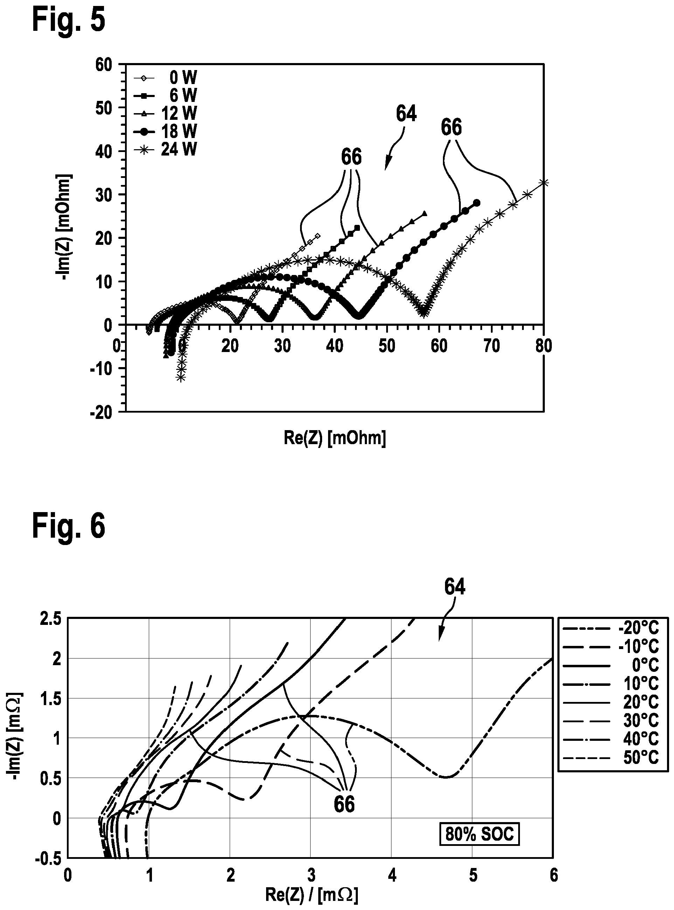

As a first example, with respect to Fig. 5, a state of health estimation will be described. Fig. 5 shows a Nyquist plot with impedance values 64 and impedance curves 66 of a new and aged Lithium-Titanite battery cell 20, i.e. with different states 54 of health. The most left curve 66 corresponds to the newest battery cell 20. The most right curve 66 corresponds to the oldest battery cell 20. The age in weeks (W) is depicted in the upper left corner of the diagram.

Because of the differences in the impedance curves 66, especially in the linear section corresponding to the Warburg impedance, parameters of this section, such as an axis cross section, can be used as a function of ageing. A state 54 of health can be determined from such parameters, for example with a lookup table or a predefined function, which relates to the axis cross section with the state 54 of health.

Since this Warburg impedance can be determined from lower frequencies, it can be used with a power supply 12 with electrical filter 30. For example, a maximum frequency that can be provided to a battery storage system 16 is around 120 Hz. In this case, solely the right linear parts of the impedance curves 66 are present and the Warburg impedance and/or parameters of these curves 66 can be obtained.

Since the impedance values 64 and/or impedance curves 66 may also depend on a temperature of the battery cells 20, it may be that, when the temperature of the battery cells 20 is varying, a battery device temperature 62 is measured and this temperature 62 is additionally used for estimating the state 54 of health. For example, the lookup table and/or the predefined function mentioned above additionally may depend on the measured battery device temperature 62. The state 54 of health of the battery device 22 may be estimated from the battery device temperature 62 and the impedance values 64.

As a second example, with respect to Fig. 6, an internal temperature estimation as state 54 will be described. Fig. 6 shows a Nyquist plot with impedance values 64 and impedance curves 66 of a Lithium-Titanite battery cell 20 at different temperatures. The most left curve 66 corresponds to the highest temperature. The most right curve 66 corresponds to lowest temperature. The corresponding temperatures are depicted at the right of the diagram. All curves 66 have been determined at a state of charge of the battery cell 20 of 80%.

For example, a temperature offset between the outside of the battery cell 20, which may be measured with the help of a sensor, and the cell interior may be determined with the help of the impedance values 64 and/or impedance curves 66. Again, the linear section corresponding to the Warburg impedance can be used and parameters of this section, such as an axis cross section, can be used as a function of the temperature offset.

An external battery device temperature 62 may be measured and the state 54 of the battery device 22 may be an internal temperature of the battery device 22, which is estimated from the external battery device temperature 62 and the impedance values 64. It may be that the estimation is done at a specific state of charge and/or that a known state of charge is included into the estimation.

As a further example, it is also possible that a temperature of the battery device 22 as state 54 is determined from the impedance values 64. The linear section corresponding to the Warburg impedance can be used and parameters of this section, such as an axis cross section, can be used as a function of the temperature. It may be that the estimation is done at a specific state of charge and/or that a known state of charge is included into the estimation.

It has to be noted that the method as described with respect to Fig. 5 and 6 also may be performed with other types of battery cells 20 and/or battery devices 22. In particular, any type of electrochemical cells has analogous equivalent circuits and Warburg impedances, which may be used for the estimation of different states.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: high power system
- 12: battery power supply
- 14: high power device
- 16: battery storage system
- 18: electrical converter
- 19: controller
- 20: battery cell
- 22: battery device
- 24: controller
- 26: DC-to-DC converter
- 28: DC link
- 30: electrical filter
- 32: inductor
- 34: capacitor
- 36: protection and connection circuit
- 38: battery modules
- 40: battery thermal management unit
- 42: switch
- 43: input
- 44: fuse
- 46: electric element
- 48: current sensor
- 50: battery cell monitoring unit
- 52: battery thermal management unit controller
- 54: state
- 56: excitation signal
- 58: current
- 60: voltage
- 62: temperature
- 64: impedance values
- 66: impedance curve
- 68: equivalent circuit
- 70: frequency range

## Claims

1. A method for estimating a state (54) of a battery device (22), wherein the battery device (22) is connected with an electrical converter (18) for supplying and/or driving a high power system (10), the method comprising:
controlling the electrical converter (18) to generate an excitation signal (56) for the battery device (22), wherein the excitation signal (56) is generated for a plurality of frequencies;
measuring a current (58) through the battery device (22) and a voltage (60) across the battery device (22) for the plurality of frequencies;
determining impedance values (64) of the battery device (22) for the plurality of frequencies from the current (58) and the voltage (60) measured at the plurality of frequencies;
estimating the state (54) of the battery device (22) from the impedance values (64).

2. The method of claim 1,
wherein the excitation signal (56) is generated in a frequency range (70), in which the battery device (22) behaves like a Warburg impedance.

3. The method of claim 1 or 2,
wherein the battery device (22) is connected via an electrical filter (30) with the electrical converter (18).

4. The method of one of the previous claims,
wherein the plurality of frequencies are in a frequency range (70) with an upper limit of 200 Hz.

5. The method of one of the previous claims,
wherein the electrical converter (18) is controlled to scan a frequency range (70) with the excitation signal (56).

6. The method of one of the previous claims,
wherein the state (54) is one of temperature, state of charge and state of health of the battery device (22).

7. The method of one of the previous claims,
wherein an external battery device temperature (62) is measured;
wherein the state (54) of the battery device (22) is an internal temperature of the battery device (22), which is estimated from the external battery device temperature (62) and the impedance values (64).

8. The method of one of claims 1 to 6,
wherein a battery device temperature (62) is measured;
wherein the state (54) of the battery device (22) is a state of health of the battery device (22), which is estimated from the battery device temperature (62) and the impedance values (64).

9. The method of one of the previous claims,
wherein the battery device (22) is at least a part of a battery storage system (16), the battery storage system (16) comprising a plurality of battery cells (20), which are connected in parallel and/or in series;
wherein the battery storage system (16) is connected to the electrical converter (18) and/or the excitation signal (56) is supplied to the battery storage system (16);
wherein a state (54) is estimated for each battery cell (20) of the battery storage system (16).

10. The method of one of the previous claims,
wherein the battery device (22) comprises a Lithium-Titanite battery cell.

11. The method of one of the previous claims,
wherein the high power system (10) is a vehicle.

12. A computer program for estimating a state (54) of a battery device (22), which, when being executed by a processor, is adapted for performing the method of one of the previous claims.

13. A computer-readable medium in which a computer program according to claim 12 is stored.

14. A controller (19, 24) for estimating a state (54) of a battery device (22), which is adapted for performing the method of one of claims 1 to 11.

15. A power supply (12) of a high-power system (10), the power supply (12) comprising:
a battery storage system (16) comprising a plurality of battery cells (20);
a battery device (22) composed of at least some of the battery cells (20);
an electrical converter (18) connected to the battery storage system (16) and adapted for supplying and/or driving the high-power system (10);
a controller (19, 24) according to claim 14.
